# EUROPÄISCHE PATENTSCHRIFT

(11) **EP 2 561 736 B1**
(45) Veröffentlichungstag und Bekanntmachung des Hinweises auf die Patenterteilung: **26.11.2014**
(21) Anmeldenummer: 11708252.9
(22) Anmeldetag: 15.03.2011
(51) Int. Cl.: H05K 7/20, B01D 46/00, B01D 46/10, B01D 46/42, B01D 46/44, F24F 11/00

(54) **FILTERLÜFTER**
FAN-AND-FILTER UNIT
AÉRATEUR FILTRANT

(30) Priorität: 19.04.2010 DE 102010016519
(43) Veröffentlichungstag der Anmeldung: 27.02.2013
(73) Patentinhaber: RITTAL GmbH & Co. KG, 35745 Herborn (DE)
(72) Erfinder: HARTMANN, Reiner, 35435 Wettenberg (DE); LEHNERT, Bernd, 35633 Lahnau (DE); SCHNEIDER, Stefan, 35080 Bad Endbach (DE)
(74) Vertreter: Tönhardt, Marion
(86) Internationale Anmeldenummer: PCT/EP2011/053837
(87) Internationale Veröffentlichungsnummer: WO 2011/131421

(56) Entgegenhaltungen:
- WO-A2-02/063936
- DE-U1-202006 015 789
- DE-U1-202008 006 067
- US-A- 5 917 141
- US-A- 5 955 955

## Beschreibung

Die Erfindung bezieht sich auf einen Filterlüfter zum Einbau in einer Wand eines Schaltschrankes oder Gehäuses mit einer in ein Lüftergehäuse eingesetzten Lüftereinheit, einer dieser vorgelagerten Filtermattenanordnung und einer diese fixierenden Lüfterabdeckung, wobei der Filterlüfter mit einer Filtermattenüberwachungseinheit versehen ist, mit der eine Einsatzdauer und/oder ein Verschmutzungsgrad der Filtermattenanordnung erfassbar ist/sind und die einen in die Lüfterabdeckung integrierten Einsatz mit einer von der der Lüftereinheit abgewandten Außenseite der Lüfterabdeckung aus sichtbaren Leuchtanzeige aufweist, mit der zumindest ein Überschreiten einer vorgegebenen oder vorgebbaren Einsatzdauer und/oder eines vorgegebenen oder vorgebbaren Verschmutzungsgrades anzeigbar ist, wobei in der Lüfterabdeckung eine an den Einsatz angepasste Aussparung ausgebildet ist, in der der Einsatz aufgenommen ist, und die Filtermattenüberwachungseinheit eine Zeitgebereinrichtung zum Feststellen der Einsatzdauer der Filtermattenanordnung und/oder eine Verschmutzungssensorik mit mindestens einem Sensorelement zum Feststellen des Verschmutzungsgrades der Filtermattenanordnung sowie eine Überwachungselektronik aufweist, in der von der Zeitgebereinrichtung und/oder der Verschmutzungssensorik abgegebene Signale auswertbar sind und mindestens ein Ansteuersignal für die Leuchtanzeige erzeugbar ist. Ein derartiger Filterlüfter ist aus der US 5,955,955 A bekannt. Die DE 20 2006 015 789 U1 beschreibt einen ähnlichen Filterlüfter.

Bei einer Kombination von Zeitgebereinrichtung und Verschmutzungssensorik kann dabei eine erhöhte Zuverlässigkeit der Filtermattendiagnose erzielt werden und die Leuchtanzeige entweder aufgrund eines von der Verschmutzungssensorik oder der Zeitgebereinrichtung abgegebenen Signals oder aber auf der Basis eines Signals angesteuert werden, das sich aus einer vorherigen Verrechnung der von der Verschmutzungssensorik und der Zeitgebereinrichtung abgegebenen Signale basiert. Auf diese Weise kann nach Ablauf eines Wartungsintervalls und/oder bei Überschreiten eines vorgegebenen Verschmutzungsgrades die Leuchtanzeige mit einem Ansteuersignal zum Filtermattenwechsel angesteuert werden und eine entsprechende Warnanzeige erzeugen.

Ein weiterer Filterlüfter zum Einbau in einen Durchbruch einer Wand eines Schaltschrankes oder eines Gehäuses ist in der DE 198 60 433 B4 angegeben. Der Filterlüfter weist ein Lüftergehäuse aus, in dem eine Lüftereinheit mit Elektromotor und Lüfterrad zum Ansaugen von Luft aus dem Außenraum in das Schrankinnere oder zum Ausblasen von Luft aus dem Schrankinneren angeordnet ist und das zur Außenseite hin von einem Lamellengitter mit waagrechten Lamellen und dazwischen angeordneten Luftdurchtrittsöffnungen abgedeckt ist. Zwischen der Lüfterabdeckung und der Lüftereinheit ist eine Filtermatte eingesetzt, die ihrerseits mittels eines Stützrostes an der Lüfterabdeckung gehalten ist. Die Filtermatte hält in dem Strömungsweg vorhandene Schmutzpartikel zurück und kann sich je nach Einsatzgebiet des Schaltschranks bzw. Gehäuses und in Abhängigkeit ihres Aufbaus mehr oder weniger schnell zusetzen, so dass die Luftförderleistung und die Filterwirkung des Filterlüfters mit der Zeit erheblich eingeschränkt sein können. Daher ist es wichtig, die Filtermatte von Zeit zu Zeit zu erneuern. Dies kann von einem Anwender leicht vergessen werden.

Ein weiterer Filterlüfter dieser Art ist in der DE 93 06 032 U1 gezeigt, woraus auch ein Querschnitt eines Filtergehäuses ersichtlich ist, das einen in etwa trichterförmigen Aufbau besitzt, so dass sich auch bei relativ kleiner Lüftereinheit eine relativ große Lufteintritts- bzw. Luftaustrittsöffnung ergibt, die im Bereich der Wand des Schaltschranks oder Gehäuses liegt und von der Filtermatte überdeckt ist.

Ein weiterer Filterlüfter ist in der DE 10 2004 013 318 B4 gezeigt, wobei dieser Filterlüfter jedoch in ein größeres Gehäuse mit Lufteintritts- und Luftaustrittsöffnungen eingebaut ist und ein spezieller Strömungskanal gebildet ist, um Tauwasserprobleme zu vermeiden. Hierbei sind ein Filtergehäuse und ein Lüftergehäuse in der größeren Gehäuseeinheit bezüglich der vertikalen Schrankwand vertikal nebeneinander liegend angeordnet, um einen vertikalen Luftkanal zu bilden.

In der DE 197 14 838 C2 ist eine Schaltschrankklimatisierungseinrichtung gezeigt, die unter anderem eine Klimatisierungseinheit in Form eines Ventilators aufweist, sowie eine Filtermattenüberwachung. Diese ist Teil einer übergeordneten Schaltschranküberwachungs- und Steuereinrichtung, in der Fehlerdaten und Einschaltzeiten umfassende Diagnosedaten speicherbar sind und die an einen Personalcomputer als Bedienungseinrichtung über eine Schnittstelle anschließbar ist. Eine solche Filtermattenüberwachungseinrichtung ist relativ aufwändig und hauptsächlich für Servicepersonal geeignet.

Weitere gattungsgemäße Vorrichtungen sind aus der WO 02/063936 A2 und aus der DE 20 2008 006 067 U1 bekannt.

Der Erfindung liegt die Aufgabe zugrunde, einen Filterlüfter der eingangs genannten Art bereit zu stellen, der auch dem Anwender vereinfachte Wartungsmaßnahmen bietet.

Diese Aufgabe wird mit den Merkmalen des Anspruches 1 gelöst. Hierbei ist vorgesehen, dass der Einsatz mindestens eine Aufnahmekammer für eine elektrische Energieversorgungseinheit, für die Zeitgebereinrichtung, für die Überwachungselektronik und/oder für mindestens ein Sensorelement aufweist, und dass der Einsatz von der Innenseite oder Außenseite her an der Lüfterabdeckung befestigt, insbesondere abnehmbar eingerastet oder angeschraubt ist, wobei entweder alle Komponenten der Filtermattenüberwachungseinheit bis auf mindestens ein Sensorelement und/oder eine externe elektrische Energieversorgung, oder alle Komponenten der Filtermattenüberwachungseinheit einschließlich ihrer elektrischen Energieversorgung von dem Einsatz aufgenommen sind.

Durch diese Ausbildung ist der Filterlüfter selbst mit einer von dem Anwender oder Bedienpersonal leicht zu kontrollierenden Filtermattenüberwachungseinheit versehen, die infolge ihrer kompakten Ausführung praktisch nicht störend eingebaut ist und dem Anwender sowie Bedienpersonal eine gut erkennbare Zustandsanzeige bietet.

Eine auf unterschiedliche Einsatzfälle eines Schaltschranks oder eines Gehäuses vorteilhaft abgestimmte oder abstimmbare Ausbildung besteht darin, dass Eingabemittel vorhanden sind, über die von einer Bedienperson verschiedene Einstellwerte für Einsatzbedingungen des Schaltschranks oder Gehäuses oder direkt Einsatzdauern oder Verschmutzungsgrade für den Austausch der Filtermattenanordnung eingebbar sind. Bei Eingabe von Einstellwerten für Einsatzbedingungen des Schaltschranks oder Gehäuses ermittelt die Filtermattenüberwachungseinheit in einer Überwachungselektronik eine angemessene Einsatzdauer oder Schwelle für einen Verschmutzungsgrad selbst, wobei z. B. in einer staub- oder feuchtigkeitsbeladenen Umgebung eine kürzere Einsatzdauer bis zum Filterwechsel vorgegeben wird.

Ist vorgesehen, dass die Leuchtanzeige eine Leuchtdiodenanordnung aufweist, mit der Licht mindestens zweier unterschiedlicher Farben abgebbar ist, so kann bereits vor Ablauf eines Wartungsintervalls oder vor Erreichen eines unzulässigen Verschmutzungsgrades dem Anwender bzw. Wartungspersonal ein Hinweis auf einen bevorstehenden Filtermattenwechsel gegeben werden. Beispielsweise ist eine dreistufige Farbanzeige von Vorteil mit Grün für einen vorschriftsmäßigen Filtermattenzustand, Gelb für einen baldigen Filtermattenwechsel und Rot bei erforderlichem Filtermattenwechsel, wobei ein besonders akuter Filtermattenzustand zudem noch durch eine Blinkanzeige signalisiert werden kann.

Mit der Maßnahme, dass die Zeitgebereinrichtung einen Betriebszeitmesser für den Lüfterbetrieb aufweist, kann das Wartungsintervall auf die reine Betriebszeit der Lüftereinheit (summierte Einschaltzustände des Lüftermotors) abgestimmt werden oder die Betriebszeit des Lüfters kann zur Gewichtung (Verkürzung oder Verlängerung) des Wartungsintervalls eingerechnet werden. Auch hierbei ist eine Verrechnung mit dem Signal der Verschmutzungssensorik oder eine parallele Auswertung zu demselben zum Erzeugen des Ansteuersignals für die Leuchtanzeige möglich.

Ist der Einsatz in die Lüfterabdeckung integriert, kann diese ohne Weiteres vollständig von dem Lüftergehäuse beim Filtermattenwechsel abgenommen werden. In Kombination mit der Leuchtdiodenanordnung als Leuchtanzeige wird ein möglichst geringer Energieverbrauch unterstützt, wobei eine kleine Einheit zur elektrischen Energieversorgung genügt.

Eine weitere vorteilhafte Ausgestaltung besteht darin, dass die Zeitgebereinrichtung und/oder die Verschmutzungssensorik zum Detektieren der Betriebszeit und/oder der Betriebszustände der Lüftereinheit eine Erfassungseinrichtung aufweist, die drahtgebunden oder drahtlos mit der Lüftereinheit zur Signalerfassung gekoppelt ist und Detektionssignale an die Zeitgebereinrichtung liefert, auf deren Basis die Betriebszeit und/oder der Betriebszustand der Lüftereinheit seit dem letzten Filtermattentausch ermittelt wird. Auf der Grundlage der Signale der Erfassungseinrichtung können die Betriebszeit bzw. die Betriebszustände (z. B. Hochlast oder Niedriglast) der Lüftereinheit bei der Bildung des Ansteuersignals für die Leuchtanzeige einbezogen werden, um z. B. die ermittelten Betriebszeiten des Lüfters einzubeziehen und/oder z. B. aus Belastungsänderungen des Lüftermotors mit zunehmender Filtermattenverschmutzung Rückschlüsse zu ziehen auf den Verschmutzungsgrad.

Vorteilhafte Ausgestaltungsvarianten bestehen darin, dass die Verschmutzungssensorik einen Strömungssensor, einen Drucksensor, einen Temperatursensor, einen optischen Sensor, einen elektrischen Feldsensor, einen Magnetfeldsensor oder einen elektrischen Leitfähigkeitssensor oder eine Kombination mindestens zweier dieser Sensoren umfasst, wobei die Sensoren ein oder mehrere Sensorelemente aufweisen. Ein optischer Sensor kann dabei z. B. mit Lichtsender und Lichtempfänger als reflektiertes Licht messender Sensor oder als Transmissionssensor ausgebildet sein, ein elektrischer Feldsensor als kapazitiver Sensor, ein elektrischer Leitfähigkeitssensor bzw. Widerstandssensor als Strom- oder Spannungsmesssensor mit z. B. zwei beabstandeten Elektroden, die mit der Filtermatte in Kontakt gebracht sind, insbesondere wenn in der Filtermatte leitende Bestandteile enthalten sind, wie z. B. bei Maßnahmen zur elektromagnetischen Abschirmung, oder sich Widerstandsänderungen in feuchter Umgebung ergeben.

Vorteile für den Aufbau ergeben sich ferner dadurch, dass in der Lüfterabdeckung eine an den Einsatz angepasste Aussparung ausgebildet ist.

Für die Funktion und Bedienung sind des Weiteren die Maßnahmen von Vorteil, dass die Aussparung im Bereich einer Gitterstruktur mit Luftaustrittsöffnungen der Lüfterabdeckung angeordnet ist. Beispielsweise lässt sich der Einsatz vorteilhaft mit einem als Einsatz ausgebildeten Herstellerlogo kombinieren und sich gleichzeitig eine Außenfläche einer Deckseite des Einsatzes zum Aufbringen des Logos verwenden.

Die Erfindung wird nachfolgend anhand von Ausführungsbeispielen unter Bezugnahme auf die Zeichnungen näher erläutert. Es zeigen:
- Fig. 1: eine perspektivische Darstellung eines auseinander gezogenen Filterlüfters,
- Fig. 2: eine Ansicht eines Filterlüfters von der Rückseite,
- Fig. 3: einen Ausschnitt des Filterlüfters im Bereich einer Lüfterabdeckung von deren Rückseite,
- Fig. 4: verschiedene Ansichten eines Einsatzes des Filterlüfters,
- Fig. 5: eine Lüftereinheit des Filterlüfters mit zwei verschiedenen Strömungsrichtungen angesaugter bzw. ausgeblasener Luft und
- Fig. 6: eine schematische Darstellung einer Filtermattenüberwachungseinheit und eines an eine Lüftersteuerung angeschlossenen Lüftermotors.

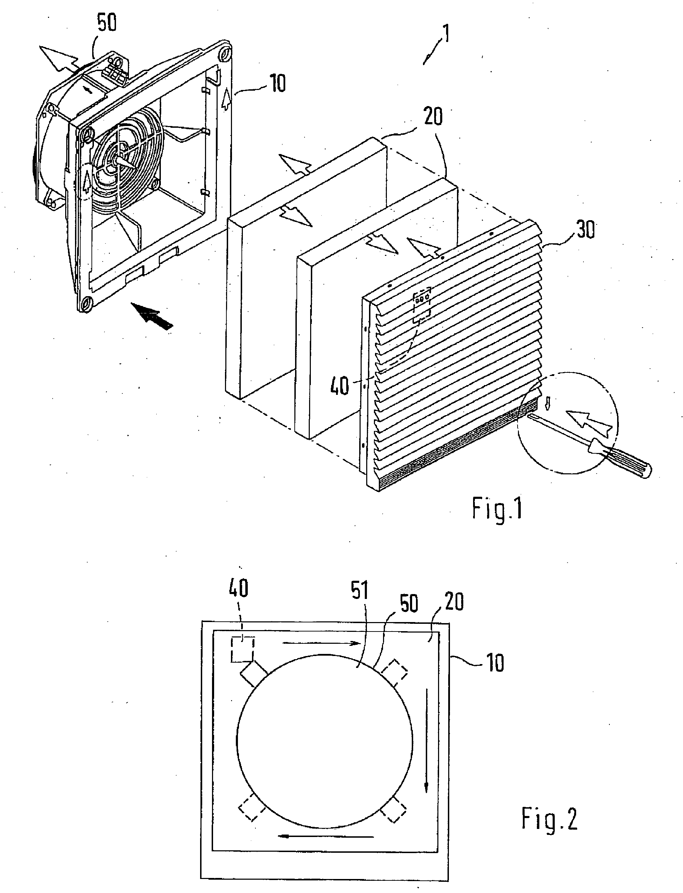

Fig. 1 zeigt einen Filterlüfter 1 in perspektivischer Darstellung, der sich aus einem Lüftergehäuse 10 mit darin eingesetzter Lüftereinheit 50 mit Lüftermotor 51 (vgl. Fig. 2), einer Filtermattenanordnung 20 sowie einer Lüfterabdeckung 30 zusammensetzt und ferner eine Filtermattenüberwachungseinheit 40 aufweist.

Das Lüftergehäuse 10 besitzt auf seiner der Lüfterabdeckung 30 zugekehrten Vorderseite eine große, beispielsweise rechteckförmige oder quadratische Öffnung, die von einem umlaufenden rechteckförmigen bzw. quadratischen Rahmen umgeben ist und nach hinten trichterartig mit sich an den Rahmen anschließenden Wandabschnitten verjüngt ist und somit eine pyramidenstumpfförmige Gestalt aufweist, deren von der Vorderseite abgekehrte, parallele Rückseite von einem Wandabschnitt abgeschlossen ist. In dem rückseitigen Wandabschnitt des Filtergehäuses 10 ist eine runde Öffnung eingebracht, die von einem nach hinten abstehenden zylindrischen Abschnitt umgeben ist, welcher den Lüftermotor und ein von diesem angetriebenes Lüfterrad aufnimmt. Die Lüftereinheit 50 ist auf ihrer Vorderseite und vorteilhaft auch auf ihrer Rückseite mit einem Schutzgitter versehen.

Die Filtermattenanordnung 20 ist vorliegend aus zwei Filtermatten, nämlich einer Standardfiltermatte (A) und einer Feinfiltermatte (B), zusammengesetzt und deckt die vordere Öffnung des Lüftergehäuses 10 vollständig ab. Alternativ kann die Filtermattenanordnung 20 auch nur eine oder mehr als zwei Filtermatten aufweisen. Ferner sind Ausgestaltungen der Filtermattenanordnung 20 mit mehr oder weniger poröser Mattenstruktur, membranartiger Mattenstruktur z. B. zur Abschirmung von Feuchtigkeit in Feuchträumen, und/oder mit elektromagnetischer Abschirmwirkung einsetzbar, die als zusätzliche Filtermatten eingesetzt werden können oder wobei eine Filtermatte an sich eine oder mehrere dieser Eigenschaften besitzen kann. Beispielsweise können in die Filtermatte elektrisch leitende Komponenten, etwa als leitfähiges Material, leitfähige Partikel oder leitfähige Fäden eingebracht sein, womit ein entsprechender elektrischer Leitwert bzw. Widerstand verbunden ist. Die Filtermattenanordnung 20 kann auch mehr oder weniger stark porös bzw. luftdurchlässig ausgebildet sein, womit sie für die Luftströmung einen entsprechenden Strömungswiderstand bildet, der jedoch bei möglichst guten Filtereigenschaften möglichst gering sein sollte. Die Filtermattenanordnung 20 wird z. B. mittels der Lüfterabdeckung 30 an dem die vordere Öffnung des Lüftergehäuses 10 umgebenden Rahmen festgelegt, wobei sie zuvor auf der Rückseite der Lüfterabdeckung 30 mittels einer Haltevorrichtung z. B. in Form eines rostartigen Haltegitters an der Lüfterabdeckung 30 fixiert sein kann.

Die Lüfterabdeckung 30 ist als Lamellengitter mit horizontal verlaufenden Lamellen mit nach unten abfallender Oberseite und dahinter oder dazwischen angeordneten Luftdurchtrittsspalten ausgebildet (die in Fig. 1 nicht sichtbar sind), wobei die Lamellen eine zu der Vorderseite im Querschnitt sägezahnförmige Struktur bilden. Die Lüfterabdeckung 30 wird auf den vorderen Rahmen des Lüftergehäuses 10 mit ihrem Zentrum etwa in der gedachten Verlängerung der Rotorachse der Lüftereinheit 50 aufgesetzt und dort fixiert, insbesondere verrastet, wobei in einem unteren Eckbereich ein z. B. mittels eines Werkzeugs freigebbarer federnder Rastfinger im aufgesetzten Zustand der Lüfterabdeckung 30 in eine angepasste Rastaufnahme des Lüftergehäuses 10 im Bereich des vorderen Rahmens eingreift. Ferner ist in der Lüfterabdeckung 30, beispielsweise in einem oberen Eckbereich, die Filtermattenüberwachungseinheit 40 mit einer von außen sichtbaren Leuchtanzeige aufgenommen.

Fig. 2 zeigt den Filterlüfter 1 mit der in das Lüftergehäuse 10 eingesetzten Lüftereinheit 50 mit Lüftermotor 51 von der Rückseite, wobei auch (bei angenommener, real nicht vorhandener) durchsichtiger Darstellung der rückseitigen Lüftergehäusewandungen die Filtermattenanordnung 20 sowie die Filtermattenüberwachungseinheit 40 zu sehen sind.

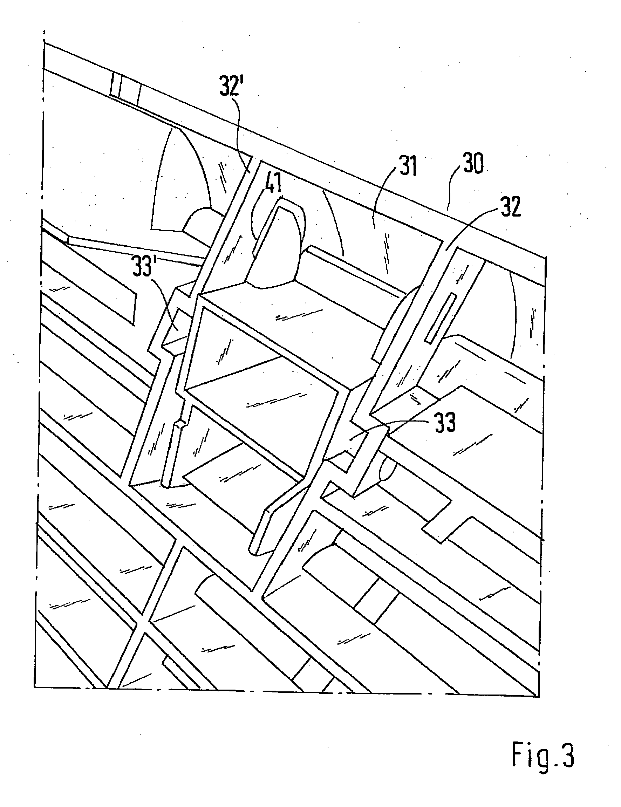

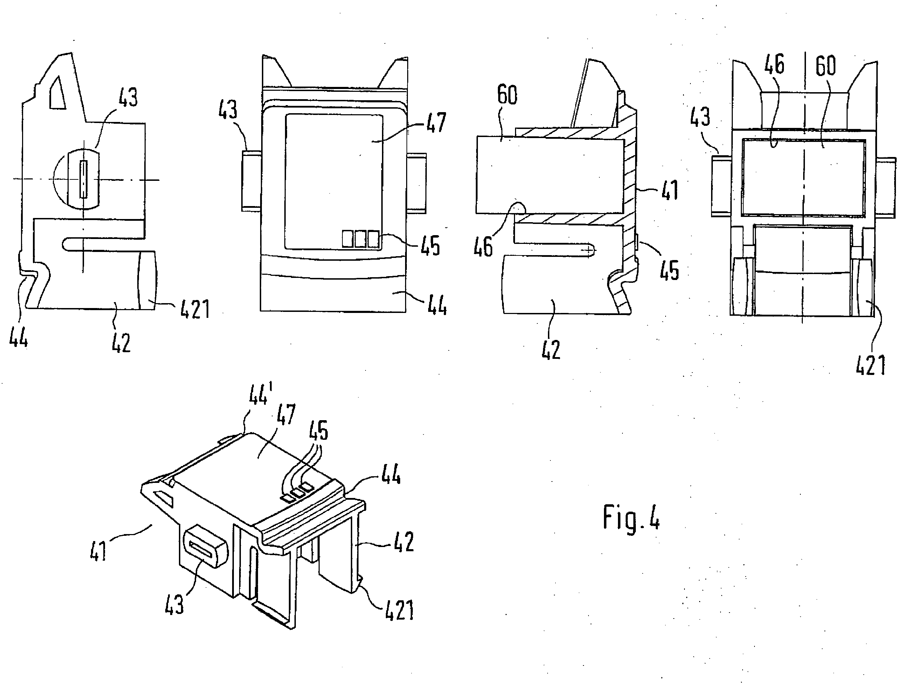

Fig. 3 zeigt einen Ausschnitt der Lüfterabdeckung 30 von deren Rückseite. Im Bereich des oberen (oder alternativ unteren) Randes der Lüfterabdeckung 30, in dem sich Lamellen und dazwischen liegende spaltförmige Durchtrittsöffnungen für die Luft befinden, ist auf der Rückseite der Lüfterabdeckung 30 eine Aussparung 31 eingeformt, die zwei senkrecht zur Ebene der Lüfterabdeckung 30 rechtwinklig zu den Lamellen verlaufende, zueinander parallele wandartige Begrenzungen 32 aufweist und an ihrem oberen Rand von einem horizontal verlaufenden Rand der Lüfterabdeckung 30 und an ihrem unteren Rand von einer horizontal verlaufenden Lamellenwand begrenzt ist. In den Begrenzungen 32 sind etwa in ihrem mittleren Bereich die Aussparung 31 nach außen erweiternde, senkrecht zur Ebene der Lüfterabdeckung 30 gerichtete Führungsnuten 33, 33' ausgebildet. Die Aussparung 31 bildet insgesamt einen quaderartigen Hohlraum, der lediglich an seinem oberen Randbereich etwas abgerundet ist und nimmt einen Einsatz 41 der Filtermattenüberwachungseinheit 40 auf, wobei seitliche Führungszapfen 43 des Einsatzes 41 in die Führungsnuten 33, 33' eingreifen, wie mit Fig. 4 verdeutlicht wird.

Fig. 4 zeigt ein Ausführungsbeispiel für den Einsatz 41 in einer perspektivischen Darstellung (unten) sowie (oben von links nach rechts) in einer Ansicht von der rechten Seite, in Draufsicht auf eine Deckseite 47 in einer Querschnittsdarstellung von der linken Seite und von unten. Der Einsatz 41 ist bezüglich einer vertikalen Mittellängsebene bis auf die Anordnung von Leuchtanzeigen 45 bzw. deren Aufnahmeöffnungen symmetrisch ausgebildet. Von der im eingebauten Zustand des Einsatzes 41 zur Vorderseite des Filterlüfters 1 gerichteten Deckseite 47 erstrecken sich seitlich angeformte Wandabschnitte sowie federnde Rastfinger 42 mit Rastabsätzen 421 rechtwinklig nach hinten. An den Wandabschnitten sind die Führungszapfen 43 nach außen abstehend angeformt. Die Deckseite 47 ist von bezüglich der beiden Wandabschnitte quer (im Beispiel etwas gerundet) verlaufenden Einpassabsätzen 44 begrenzt, wobei die Rastfinger 42 an einem nach hinten abgesetzten, an die Deckseite 47 anschließenden Abschnitt angeformt sind, der zu seinem von dem betreffenden Einpassabsatz 44 abliegenden freien Rand hin leicht zur Vorderseite hin gerichtet ist, d.h. einen Winkel von weniger als 90° gegenüber der Ebene der Deckseite 47 bildet. In der Deckseite 47 bzw. der dortigen Wandung des Einsatzes 41 sind drei in Querrichtung nebeneinander liegende Aufnahmeöffnungen für die Leuchtanzeige 45 ausgebildet, um z. B. drei Leuchtdioden für verschiedenfarbiges Licht (vorzugsweise rot, gelb, grün) einzusetzen. Alternativ kann auch z. B. nur eine Aufnahmeöffnung für eine Leuchtanzeige, insbesondere Leuchtdiode, vorgesehen sein, die zum Signalisieren lediglich Licht einer Farbe oder Licht mehrerer Farben abhängig von ihrer Ansteuerung aussenden kann. Ferner ist in dem Einsatz 41, wie insbesondere die beiden Darstellungen oben rechts zeigen, eine Aufnahmekammer 46 zur Aufnahme von Komponenten der Filtermattenüberwachungseinheit 40, wie z. B. ein oder mehrere Sensorelemente, eine elektrische Energieversorgung und/oder elektronische Schaltungskomponenten, angeordnet. Die Aufnahmekammer 46 ist auf ihrer von der Deckseite 47 abgekehrten Rückseite offen und auf ihrer Vorderseite von der Deckseite 47 bzw. deren Wandung, seitlich von den Seitenwandabschnitten und zwischen den Seitenwandabschnitten von quer verlaufenden Wandabschnitten begrenzt und bildet somit einen zur Rückseite hin offenen quaderförmigen Hohlraum.

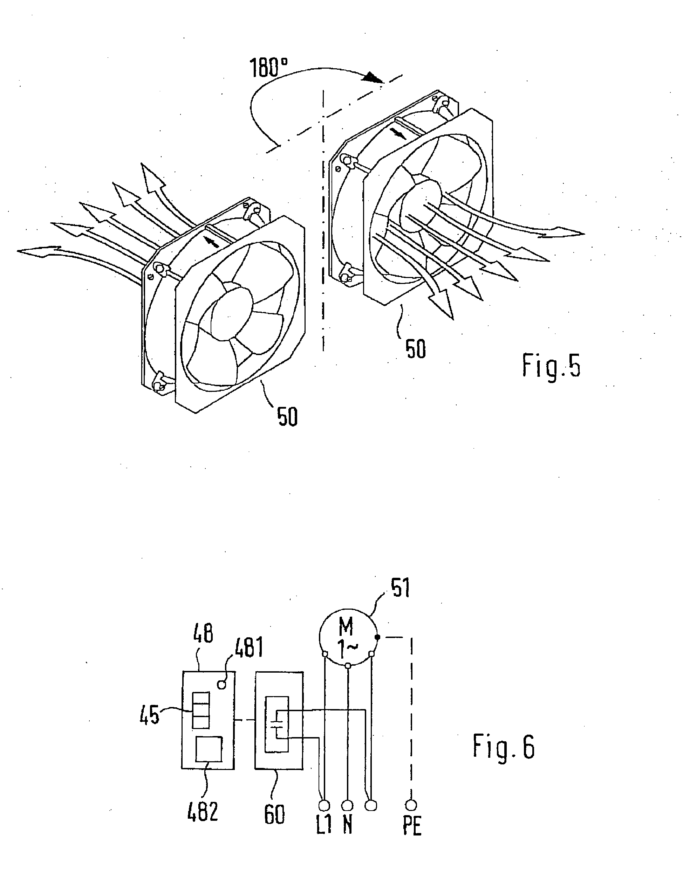

Wie die Fig. 5 zeigt, können die Lüftereinheiten 50 alternativ zum Ansaugen oder zum Ausblasen von Luft durch entsprechende Ansteuerung des Lüftermotors 51 betrieben werden. Wird also der Filterlüfter in eine Wand eines Schaltschranks oder Gehäuses eingebaut, so kann demnach Luft zum Kühlen durch das Lamellengitter der Lüfterabdeckung 30 in den Schaltschrank eingesaugt oder Warmluft aus diesem ausgeblasen werden. Zum Einsatz des Filterlüfters wird in die Wand des Schaltschranks bzw. Gehäuses ein an den Rahmen um die Öffnung des Lüftergehäuses 10 angepasster Ausschnitt eingebracht, so dass der Rahmen mit einem umlaufenden Randabschnitt auf der Wand flanschartig anliegt, wie in den eingangs genannten Druckschriften DE 198 60 433 B4 und DE 93 06 032 U1 gezeigt, auf die insoweit Bezug genommen wird. Zum Filtermattenwechsel bleibt der Filterlüfter 1 mit seinem Lüftergehäuse 10 und der darin aufgenommenen Lüftereinheit 50 an dem Schaltschrank bzw. Gehäuse angebaut, und es wird lediglich die Lüfterabdeckung 30 abgenommen. Da die Filtermattenüberwachungseinheit 40 mit dem Einsatz 41 und betreffenden Komponenten in der Lüfterabdeckung angebracht sind, erübrigt sich für diese mit der Leuchtanzeige 45 eine separate Montage an dem Schaltschrank oder Gehäuse, wobei die Anbringung der Leuchtanzeige 45 in der Lüfterabdeckung 30, insbesondere dem Einsatz 41, für den Anwender oder Wartungspersonal von der Außenseite des Schaltschranks oder Gehäuses gut erkennbar ist, insbesondere wenn ein Filtermattenwechsel durch die Leuchtanzeige 45 signalisiert wird.

Zum Auswechseln der Filtermattenanordnung 20 reicht es in der Regel bereits, wenn die Lüfterabdeckung 30 mit geringem Abstand von dem Rahmen des Lüftergehäuses 10 entfernt, z. B. weggeklappt wird. Hierzu können flexible Anschlussdrähte der Filtermattenüberwachungseinheit 40 mit der Lüftereinheit 50 bzw. einer Ansteuereinheit derselben oder auch weiterer Steuereinrichtungen des Schaltschrankes oder Gehäuses verbunden bleiben, wobei die Länge der Anschlussdrähte ausreichend zu wählen ist. Alternativ können auch einfach zu lösende Verbindungsmittel für die Anschlussdrähte der Filtermattenüberwachungseinheit 40 vorhanden sein oder aber die Filtermattenüberwachungseinheit 40 kann ohne Anschlussdrähte zu der Lüftereinheit 50 bzw. dem Schaltschrank oder Gehäuse vollständig in der Lüfterabdeckung 30 drahtlos integriert sein. Hierzu sind in Fig. 6 gezeigte Überwachungskomponenten 48, Sensorelemente 481, eine elektrische Energieversorgung und/oder eine Überwachungselektronik 482 mit betreffenden elektronischen Schaltungskomponenten zum Teil oder vollständig von dem Einsatz 41 aufgenommen.

Die Filtermattenüberwachungseinheit 40 weist z. B. eine Zeitgebereinrichtung zum Feststellen der Einsatzdauer der Filtermattenanordnung 20 und/oder eine Verschmutzungssensorik mit mindestens einem Sensorelement 481 sowie die Überwachungselektronik 482 auf, in der von der Zeitgebereinrichtung und/oder der Verschmutzungssensorik abgegebene Signale mittels einer Verarbeitungseinrichtung verarbeitbar und auswertbar und mindestens ein Ansteuersignal für die Leuchtanzeige 45 erzeugbar ist. Ist die Leuchtanzeige z. B. als Leuchtdiodenanzeige ausgebildet, so verbraucht sie sehr wenig elektrische Energie, so dass auch die elektrische Energieversorgung miniaturisiert ausgebildet und auf engem Raum untergebracht werden kann. Als Sensoren kommen z. B. Strömungssensoren, Drucksensoren, Temperatursensoren, optische Sensoren auf Reflexionsbasis oder Transmissionsbasis, elektrische Feldsensoren, wie kapazitive Sensoren, Magnetfeldsensoren, elektrische Leitfähigkeitssensoren bzw. Widerstandssensoren oder eine Kombination mindestens zweier dieser Sensoren in Betracht, wobei die Sensoren wiederum ein oder mehrere Sensorelemente aufweisen können, etwa der optische Sensor ein Lichtsende- und ein Lichtempfangselement oder der Leitfähigkeitssensor zwei beabstandete Elektroden, die mit der Filtermattenanordnung kontaktiert werden. Derartige Sensoren können auch für die Zeitgebereinrichtung zum Ausbilden einer Erfassungseinrichtung eingesetzt werden, mit der der Betriebszustand der Lüftereinheit 50 erfasst wird, um eine Betriebszeit der Lüftereinheit 50 zu messen und die Betriebszeiten aufzusummieren, womit sich die Betriebszeit bzw. der Betriebszustand der Lüftereinheit 50 auch ohne drahtgebundenen Anschluss an eine Lüftersteuerung 60 detektieren lässt. Alternativ kann aber auch ein drahtgebundener Anschluss der Filtermattenüberwachungseinheit 40 an die Lüftersteuerung 60 z. B. zum Abgreifen eines Stromsignals oder einer Spannung zum Feststellen des Betriebs der Lüftereinheit 50 vorgesehen sein.

Mittels der genannten Sensoren lässt sich nicht nur die Betriebszeit der Lüftereinheit 50 messen, sondern bei aufwendigerer Ausgestaltung der Überwachungselektronik 482 auch der Betriebszustand der Lüftereinheit 50, z. B. ob dieser häufig im Hochlastbetrieb oder weitgehend mit niedriger Leistung betrieben wird. Diese von der Überwachungselektronik 482 gewonnenen Informationen können dann in der Überwachungselektronik 482 zur Bewertung des Zustandes der Filtermattenanordnung 20 zusätzlich herangezogen und zur Signalisierung eines Filtermattenwechsels über die Leuchtanzeige 45 genutzt werden.

Im einfachsten Fall kann ein festes Wartungsintervall mittels der Zeitgebereinrichtung vorgegeben und die Leuchtanzeige 45 zur Signalisierung des Filtermattenwechsels bei Ablauf des Zeitintervalls angesteuert werden. Alternativ oder zusätzlich kann mittels der Verschmutzungssensorik der Grad der Verschmutzung der Filtermattenanordnung 20 erfasst und bei Überschreitung eines vorgegebenen Verschmutzungsgrades (Schwelle) ein Signal zum Filtermattenwechsel über die Leuchtanzeige 45 abgegeben werden. Zudem lassen sich die Signale der Zeitgebereinrichtung und der Verschmutzungssensorik kombiniert miteinander auswerten. Eine vorteilhafte Ausbildung der Filtermattenüberwachungseinheit 40 besteht darin, dass eine Bedienperson verschiedene Einstellwerte für Einsatzbedingungen des Schaltschrankes oder Gehäuses einstellen kann, beispielsweise in einer Umgebung mit hoher Luftverschmutzung oder Feuchtigkeit bzw. niedriger Luftverschmutzung oder niedriger Feuchtigkeit. Dabei können die Eingabemittel mit der zugehörigen Überwachungselektronik 482 der Filtermattenüberwachungseinheit 40 auch so ausgebildet sein, dass eine Einsatzdauer oder ein Verschmutzungsgrad für den Filtermattenwechsel auch direkt vorgegeben werden kann.

Ist die Filtermattenüberwachungseinheit 40 mit einer programmierbaren integrierten Schaltung, wie z. B. einem Mikrocontroller ausgestattet, lassen sich unterschiedliche Überwachungsszenarien programmieren und auf diese Weise vorgeben, um die Leuchtanzeige davon abhängig zu steuern.

## Patentansprüche

1. Filterlüfter zum Einbau in einer Wand eines Schaltschrankes oder Gehäuses mit einer in ein Lüftergehäuse (10) eingesetzten Lüftereinheit (50), einer dieser vorgelagerten Filtermattenanordnung (20) und einer diese fixierenden Lüfterabdeckung (30), wobei
der Filterlüfter mit einer Filtermattenüberwachungseinheit (40) versehen ist, mit der eine Einsatzdauer und/oder ein Verschmutzungsgrad der Filtermattenanordnung (20) erfassbar ist/sind und die einen in die Lüfterabdeckung (30) integrierten Einsatz (41) mit einer von der der Lüftereinheit (50) abgewandten Außenseite der Lüfterabdeckung (30) aus sichtbaren Leuchtanzeige (45) aufweist, mit der zumindest ein Überschreiten einer vorgegebenen oder vorgebbaren Einsatzdauer und/oder eines vorgegebenen oder vorgebbaren Verschmutzungsgrades anzeigbar ist, wobei in der Lüfterabdeckung (30) eine an den Einsatz (41) angepasste Aussparung (31) ausgebildet ist, in der der Einsatz aufgenommen ist, und
die Filtermattenüberwachungseinheit (40) eine Zeitgebereinrichtung zum Feststellen der Einsatzdauer der Filtermattenanordnung (20) und/oder eine Verschmutzungssensorik mit mindestens einem Sensorelement (481) zum Feststellen des Verschmutzungsgrades der Filtermattenanordnung (20) sowie eine Überwachungselektronik (482) aufweist, in der von der Zeitgebereinrichtung und/oder der Verschmutzungssensorik abgegebene Signale auswertbar sind und mindestens ein Ansteuersignal für die Leuchtanzeige (45) erzeugbar ist,
**dadurch gekennzeichnet, dass** der Einsatz (41) mindestens eine Aufnahmekammer (46) für eine elektrische Energieversorgungseinheit, für die Zeitgebereinrichtung, für die Überwachungselektronik (482) und/oder für mindestens ein Sensorelement (481) aufweist, und dass der Einsatz (41) von der Innenseite oder Außenseite her an der Lüfterabdeckung (30) befestigt, insbesondere abnehmbar eingerastet oder angeschraubt ist, wobei entweder alle Komponenten der Filtermattenüberwachungseinheit (40) bis auf mindestens ein Sensorelement und/oder eine externe elektrische Energieversorgung, oder alle Komponenten der Filtermattenüberwachungseinheit (40) einschließlich ihrer elektrischen Energieversorgung von dem Einsatz (41) aufgenommen sind.

2. Filterlüfter nach Anspruch 1,
**dadurch gekennzeichnet, dass** Eingabemittel vorhanden sind, über die von einer Bedienperson verschiedene Einstellwerte für Einsatzbedingungen des Schaltschranks oder Gehäuses oder direkt Einsatzdauern oder Verschmutzungsgrade für den Austausch der Filtermattenanordnung (20) eingebbar sind.

3. Filterlüfter nach einem der vorhergehenden Ansprüche,
**dadurch gekennzeichnet, dass** die Leuchtanzeige (45) eine Leuchtdiodenanordnung mit der Licht mindestens zweier unterschiedlicher Farben abgebbar ist.

4. Filterlüfter nach einem der Ansprüche 1 bis 3,
**dadurch gekennzeichnet, dass** die Zeitgebereinrichtung einen Betriebszeitmesser für den Lüfterbetrieb aufweist.

5. Filterlüfter nach einem de Ansprüche 1 bis 4,
**dadurch gekennzeichnet, dass** die Zeitgebereinrichtung und/oder die Verschmutzungssensor zum Detektieren der Betriebszeit und/oder der Betriebszustände der Lüftereinheit (50) eine Erfassungseinrichtung aufweist, die drahtgebunden oder drahtlos mit der Lüftereinheit (50) zur Signalerfassung gekoppelt ist und Detektionssignale an die Zeitgebereinrichtung liefert, auf deren Basis die Betriebszeit und/oder der Betriebszustand der Lüftereinheit (50) seit dem letzten Filtermattentausch ermittelt wird.

6. Filterlüfter nach einem der Ansprüche 1 bis 5,
**dadurch gekennzeichnet, dass** die Verschmutzungssensorik einen Strömungssensor, einen Drucksensor, einen Temperatursensor, einen optischen Sensor, einen elektrischen Feldsensor, einen Magnetfeldsensor oder einen elektrischen Leitfähigkeitssensor oder eine Kombination mindestens zweier Sensoren umfasst, wobei die Sensoren ein oder mehrere Sensorelemente (481) aufweisen.

7. Filterlüfter nach Anspruch 1,
**dadurch gekennzeichnet, dass** die Aussparung (31) im Bereich einer Gitterstruktur mit Luftaustrittsöffnungen der Lüfterabdeckung (30) angeordnet ist.

## Claims

1. A fan-and-filter unit to be mounted in the wall off a switch cabinet or housing, comprising a fan unit (50) inserted in a fan housing (10), a filter mat arrangement (20) mounted upstream of the fan unit and a fan cover (30) immobilizing the filter mat, wherein
the fan-and-filter unit has a filter mat monitoring unit (40) which is designed to detect the service life and/or a degree of soiling of the filter mat arrangement (20) and which comprises an insert (41) integrated into the fan housing or the fan cover (30) and having an illuminated display (45) visible from the exterior of the fan cover (30) facing away from the fan unit (50) and being designed to display at least exceeding of a predetermined or predeterminable service life and/or a predetermined or predeterminable degree of soiling, wherein a recess (31) adapted to the insert (41) is formed in the cover (30) in which the insert is accommodated, and
the filter mat monitoring unit (40) comprises a timer means for determining the service life of the filter mat arrangement (20) und/or a soiling sensor means having at least one sensor element (481) for determining the degree of soiling of the filter mat arrangement (20) and a monitoring electronics (482) to analyze signals output by the timer means and/or the soiling sensor means and to produce at least one drive signal for the illuminated display (45),
**characterized in that** the insert (41) comprises at least one receiving chamber (46) for an electric power supply unit, for the timer means, for the monitoring electronics (482) and/or for at least one sensor element (481) and that the insert (41) is attached to the fan cover (30) from inside or outside, in particular detachably snapped in or screwed thereto, wherein either all components of the filter mat monitoring unit (40) except at least one sensor element and/or an external electric power supply or all components of the filter mat monitoring unit (40) including their electric power supply are received by the insert (41).

2. The fan-and-filter unit of claim 1, **characterized in that** input means are provided so that different set values for operating conditions of the switch cabinet or housing or directly service lives or degrees of soiling for exchanging the filter mat arrangement (20) may be input.

3. The fan-and-filter unit of any of the preceding claims, **characterized in that** the illuminated display (45) includes a light emitting diode arrangement to emit light of at least two different colors.

4. The fan-and-filter unit of any of claims 2 to 4, **characterized in that** the timer means comprises an operation timekeeper for fan operation.

5. The fan-and-filter unit of any of claims 1 to 4, **characterized in that** the timer means and/or the soiling sensor means comprises a detector means for detecting the operating time and/or the operating conditions of the fan unit which is coupled to the fan unit (50) through a wired or wireless connection for signal detection and which supplies detection signals to the timer means, the operating time and/or the operating state of the fan unit (50) since the last filter exchange being determined on basis of those detection signals.

6. The fan-and-filter unit of any of claims 1 to 5, **characterized in that** the soiling sensor means includes a flow sensor, a pressure sensor, a temperature sensor, an optical sensor, an electric field sensor, a magnetic field sensor or an electric conductivity sensor or a combination of at least two of such sensors, wherein the sensors comprise one or more sensor elements (481).

7. The fan-and-filter unit of claim 1, **characterized in that** the recess (31) is arranged in the region of a grid structure with air outlet openings of the fan cover (30).

## Revendications

1. Aérateur à filtre destiné à être monté dans une paroi d'une armoire de commande ou d'un carter, comportant une unité d'aération (50), montée dans un carter d'aérateur (10), un ensemble d'éléments filtrants (20) montés en amont de ladite unit d'aération, et un couvercle (30) fixant ledit ensemble d'éléments filtrants,
l'aérateur à filtre étant muni d'une unité de contrôle des éléments filtrants (40), qui permet de détecter une durée d'utilisation et/ou un degré d'encrassement de l'ensemble d'éléments filtrants (20) et qui comporte un insert (41), intégré dans le couvercle (30) et muni d'un témoin lumineux (45) visible depuis la face extérieure du couvercle (30), opposée à l'unité d'aération (50), qui permet de signaler au moins un dépassement de la durée d'utilisation définie ou définissable et/ou du degré d'encrassement défini ou définissable, un évidement (31) ajusté à l'insert (41) étant réalisé dans le couvercle (30) pour recevoir l'insert (41), et
l'unité de contrôle des éléments filtrants (40) comportant un dispositif de temporisation permettant de constater la durée d'utilisation de l'ensemble d'éléments filtrants (20) et/ou un système de détection d'encrassement avec au moins un élément capteur (481) permettant de détecter le degré d'encrassement de l'ensemble d'éléments filtrants (20), ainsi qu'une électronique de contrôle (482), dans laquelle peuvent être analysés les signaux délivrés par le dispositif de temporisation et/ou par le système de détection d'encrassement et dans laquelle peut être généré au moins un signal de commande pour le témoin lumineux (45),
**caractérisé en ce que** l'insert (41) comporte au moins un logement (46) pour une unité d'alimentation électrique, pour le dispositif de temporisation, pour l'électronique de contrôle (482) et/ou pour au moins un élément capteur (481), et **en ce que** l'insert (41) est fixé contre le couvercle (30) à partir de la face intérieure ou de la face extérieure, en particulier est encliqueté ou vissé de manière amovible, tous les composants de l'unité de contrôle des éléments filtrants (40), hormis au moins un élément capteur et/ou une unité d'alimentation électrique externe, ou tous les composants de l'unité de contrôle des éléments filtrants (40), y comprise son unité d'alimentation électrique, sont logés dans l'insert (41).

2. Aérateur à filtre selon la revendication 1, **caractérisé en ce qu'**il est prévu des moyens d'entrée, par lesquels une personne de service peut entrer les différentes valeurs de réglage pour les conditions d'utilisation de l'armoire de commande ou du carter ou par lesquels sont entrés directement les durées d'utilisation ou les degrés d'encrassement pour le remplacement de l'ensemble d'éléments filtrants (20).

3. Aérateur à filtre selon l'une quelconque des revendications précédentes, **caractérisé en ce que** le témoin lumineux (45) est un ensemble de diodes électroluminescentes qui permet d'émettre la lumière dans au moins deux couleurs différentes.

4. Aérateur à filtre selon l'une quelconque des revendications 1 à 3, **caractérisé en ce que** le dispositif de temporisation comporte un dispositif de mesure du temps de service pour le fonctionnement de l'aérateur.

5. Aérateur à filtre selon l'une quelconque des revendications 1 à 4, **caractérisé en ce que** le dispositif de temporisation et/ou le capteur d'encrassement, pour la détection de la durée de service et/ou des états de service de l'unité d'aération (50), comportent un dispositif de détection qui est couplé par fil ou sans fil à l'unité d'aération (50) pour détecter des signaux et délivre des signaux de détection au dispositif de temporisation, sur la base desquels sont déterminés la durée de service et/ou l'état de service de l'unité d'aération (50) depuis le dernier remplacement des éléments filtrants.

6. Aérateur à filtre selon l'une quelconque des revendications 1 à 5, **caractérisé en ce que** le dispositif de détection d'encrassement comporte un capteur de circulation, un capteur de pression, un capteur de température, un capteur optique, un capteur de champ électrique, un capteur de champ magnétique ou un capteur de conductivité électrique ou une combinaison d'au moins deux de ces capteurs, lesdits capteurs comportant un ou plusieurs éléments capteurs (481).

7. Aérateur à filtre selon la revendication 1, **caractérisé en ce que** l'évidement (31) est disposé dans la zone d'une structure en forme de grille avec des orifices de sortie d'air du couvercle (30).
